(19) Europäisches Patentamt
European Patent Office
Office européen des brevets

(11) Veröffentlichungsnummer: **0 428 863 B1**

(12) # EUROPÄISCHE PATENTSCHRIFT

(45) Veröffentlichungstag der Patentschrift: **27.09.95**

(51) Int. Cl.$^6$: **C08G 59/50**

(21) Anmeldenummer: **90119639.4**

(22) Anmeldetag: **12.10.90**

(54) **Epoxidharzmischungen.**

(30) Priorität: **24.10.89 DE 3934403**

(43) Veröffentlichungstag der Anmeldung:
**29.05.91 Patentblatt 91/22**

(45) Bekanntmachung des Hinweises auf die Patenterteilung:
**27.09.95 Patentblatt 95/39**

(84) Benannte Vertragsstaaten:
**AT BE CH DE FR GB IT LI NL**

(56) Entgegenhaltungen:
**EP-A- 0 274 646**
**EP-A- 0 384 940**

**WORLD PATENTS INDEX Derwent Publications Ltd., London, GB; AN 79-397308 & JP-A-54 047 753 (HITACHI CHEMICAL) 2. August 1980**

(73) Patentinhaber: **SIEMENS AKTIENGESELLSCHAFT**
**Wittelsbacherplatz 2**
**D-80333 München (DE)**

(72) Erfinder: **Gentzkow, Wolfgang, Dr.**
**Zwetschgenweg 1**
**D-8524 Kleinsendelbach (DE)**
Erfinder: **Huber, Jürgen**
**Am Heiligenholz 6**
**D-8520 Erlangen (DE)**
Erfinder: **Rogler, Wolfgang, Dr.**
**Frankenstrasse 44b**
**W-8521 Möhrendorf (DE)**
Erfinder: **Wilhelm, Dieter, Dr.**
**Bergstrasse 32b**
**W-8550 Forchheim (DE)**
Erfinder: **Laupenmühlen, Heinz**
**Dr.-Goerg-Dassler-Strasse 20**
**W-8551 Hemhofen (DE)**

**EP 0 428 863 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Epoxidharzmischungen zur Herstellung von Formstoffen und Verbundwerkstoffen sowie aus diesen Epoxidharzmischungen hergestellte Formstoffe und Verbundwerkstoffe.

Epoxidharze haben sich in vielen Bereichen der Elektrotechnik und Elektronik bewährt. Gründe dafür sind ein vergleichsweise niedriger Preis und die relativ einfache und sichere Verarbeitbarkeit sowie das insgesamt sehr gute dielektrische, mechanische und chemische Eigenschaftsniveau der gehärteten Epoxidharzformstoffe. Wegen der guten Grenzflächenhaftung zu Verstärkungs- und Einlagerungskomponenten sowie zu miteinander zu verbindenden Materialien, wie metallischen, mineralischen, keramischen und auch organischen Werkstoffen, kommen Epoxidharze bevorzugt zur Herstellung derartiger Verbünde zum Einsatz. Besonders bewährt haben sich Epoxidharze bei der Herstellung von Leiterplatten und zur Umhüllung und Einbettung von Bauteilen für die Elektronik und Niederspannungstechnik. In diesem Anwendungsbereich stellen die Epoxidharze sogar die führende Stoffklasse dar.

Die Verarbeitung der Epoxidharze zu Leiterplatten geschieht vorteilhaft über die Herstellung von Pregregs. Zu diesem Zweck werden anorganische oder organische Verstärkungsmaterialien bzw. Einlagerungskomponenten in Form von Fasern, Vliesen, Geweben und Flächenstoffen mit dem Harz getränkt. In den meisten Fällen geschieht dies mit einer Lösung des Harzes in einem leicht verdampfbaren Lösungsmittel. Die dabei erhaltenen Prepregs dürfen nach diesem Prozeß nicht mehr klebend, aber auch noch nicht ausgehärtet sein, vielmehr soll sich die Harzmatrix lediglich in einem vorpolymerisierten Zustand befinden. Die Prepregs müssen außerdem ausreichend lagerstabil sein. So wird beispielsweise für die Herstellung von Leiterplatten eine Lagerstabilität von mindestens 3 Monaten gefordert. Bei der Weiterverarbeitung müssen die Prepregs außerdem bei Temperaturerhöhung aufschmelzen und sich mit den Verstärkungsmaterialien bzw. Einlagerungskomponenten sowie mit den für den Verbund vorgesehenen Werkstoffen unter Druck möglichst fest und dauerhaft verbinden. Vom Verbund selbst wird hohe mechanische und thermische Festigkeit, chemische Beständigkeit und Wärmeformbeständigkeit sowie Alterungsbeständigkeit gefordert. Hinzu kommt die Forderung nach dauerhaft hohen elektrischen Isolationseigenschaften, hoher Dimensionsstabilität über einen weiten Temperaturbereich, gutem Haftvermögen zu Glas und Kupfer, hohem Oberflächenwiderstand, geringem dielektrischen Verlustfaktor, gutem Bearbeitungsverhalten (Stanzbarkeit, Bohrbarkeit), geringer Wasseraufnahme und hoher Korrosionsbeständigkeit.

Für den Einsatz in Formmassen zur Umhüllung und zum Schutz von Bauteilen für die Elektronik und Niederspannungstechnik werden Epoxidharze mit Härtern, Beschleunigern, Flammschutzmitteln, Gleit- und Trennmitteln, Pigmenten und anderen Zusatzstoffen, wie Flexibilisatoren und Kupplungsreagenzien, versetzt und mit anorganischen Füllstoffen hoch gefüllt. Die Mischungen werden im Trockenmischverfahren, Schmelzverfahren oder Imprägnierverfahren hergestellt und kommen als staubarmes rieselfähiges Granulat oder in Form von Tabletten in den Handel. Bei der Herstellung und Aufbereitung findet eine Vorreaktion der Harzmischung statt. Für die Handhabung und Weiterverarbeitung der Formmassen ist es wichtig, daß die vorreagierte Mischung einerseits bei tiefen Temperaturen sehr stabil, d.h. beispielsweise unterhalb 5 °C über 6 Monate lagerfähig ist, und andererseits bei Verarbeitungstemperatur (ca. 150 bis 180 °C) schnell aufschmilzt, gut fließfähig wird und schnell mit möglichst geringem Reaktionsschrumpf härtet. Derzeit sind bei der Umhüllung elektronischer Bauteile Zykluszeiten von wenigen Minuten bis zur Entformung realisiert. Es wird jedoch angestrebt, diese Zeit noch weiter zu reduzieren.

Mit zunehmender Miniaturisierung von mikroelektronischen Bauelementen nimmt deren Empfindlichkeit gegenüber mechanischen Spannungen zu, so daß die in herkömmlichen Hüllmassen bei Temperaturveränderungen auf die Bauteile ausgeübten Spannungen nicht mehr tolerierbar sind. In jüngerer Zeit sind deshalb sogenannte "low stress"-Preßmassen entwickelt worden, die bei Temperaturwechsel nur noch geringe Kräfte auf die Bauteile ausüben. Erreicht wird dieses "low stress"-Verhalten durch Formmassen-Zusätze, wie Organopolysiloxane und funktionelle Butadien/Acrylnitril-Polymere, die auch bei niederen Temperaturen ihre flexibilisierende Wirkung beibehalten (siehe: JP-A 62-128 162, JP-A 62-214 650 und US-A 4 701 482).

Für die Schutzfunktion der Formmassen ist es wichtig, daß sie möglichst frei von korrosiven bzw. halbleiterschädigenden Bestandteilen, wie $Cl^-$, $Br^-$ und $Na^+$, hydrolysierbarem Chlor und $\alpha$-strahlenden Verunreinigungen sind, nach der Härtung eine gute Substrathaftung aufweisen, gegen Feuchtigkeit und organische Lösungsmittel resistent und undurchlässig sind und den mechanischen und thermischen Eigenschaftsanforderungen (Biegefestigkeit > 100 N/mm$^2$, Schlagzähigkeit > 5 Nmm/mm$^2$, linearer Ausdehnungskoeffizient $\alpha$ ~15 bis 25.10$^{-6}$ K$^{-1}$) genügen.

Mit zunehmender Belastung und intensiver Nutzung der Formstoffe bzw. Verbundwerkstoffe erhält vor allem die Forderung nach Wärmeformbeständigkeit besonderes Gewicht. Ein günstiges Verhalten zeigen dabei Materialien mit hoher Glasübergangstemperatur $T_G$.Liegt diese oberhalb des bei der Bearbeitung

überstrichenen Temperaturbereiches, so ist Formstabilität gewährleistet und Schädigungen sind weitgehend ausgeschlossen. Das derzeit weltweit für FR4-Laminate im großen Maßstab eingesezte Epoxidharz weist nach der Härtung eine Glasübergangstemperatur von nur 130 °C auf. Bei der Leiterplattenfertigung werden deshalb beispielsweise beim Schwallöten (Temperatur: 260 bis 280 °C) Schädigungen und Ausfälle durch Verwölbung und Delaminierung beobachtet. Auch kurzzeitige Temperaturbelastungen von 200 °C und darüber, wie sie beispielsweise beim Bohren örtlich auftreten, können zu Schädigungen führen.

Bei der Verarbeitung von Formmassen liegen die Werkzeugtemperaturen im allgemeinen bei 150 bis 180 °C. Um bei der Formgebung eine ausreichende Entformungssteifigkeit sicherzustellen, sollte die Glasübergangstemperatur deshalb zumindest über 180 °C liegen. Zum optimalen Schutz des Bauteils sollte sie aber höher sein als die höchsten lokal auftretenden Betriebs- oder Verarbeitungstemperaturen, weil sich sonst beim Überschreiten der Glasübergangstemperatur wichtige Eigenschaften der Formstoffe sprunghaft verschlechtern. So nimmt beispielsweise die Diffusionsgeschwindigkeit von Feuchtigkeit und anderen Stoffen stark zu, die Dielektrizitätszahl und der Verlustfaktor steigen an und durch Zunahme des Wärmeausdehnungskoeffizienten nimmt die Scherbeanspruchung zwischen Formstoff und Bauteil zu und kann zu Beschädigungen des Bauteils führen. Hinsichtlich der beim Lötvorgang auftretenden Temperaturbeanspruchung sollte die Glasübergangstemperatur $T_G > 200$ °C sein.

Alle in der Elektronik eingesetzten Polymerwerkstoffe müssen ferner schwerbrennbar bzw. selbstverlöschend sein. Dadurch soll vor allem ein Schutz der häufig sehr teuren elektronischen Systeme sowie im Brandfall ein möglichst langer Funktionserhalt gewährleistet werden. Bei der Beurteilung des Brennverhaltens wird ferner zunehmend gefordert, daß eine der härtesten Materialprüfnormen bestanden wird, nämlich eine V-O-Einstufung nach UL 94V. Für diesen Test werden fünf vertikal gehalterte Probekörper (127 mm x 12,7 mm) zweimal je 10 s am unteren Ende beflammt. Um eine V-O-Einstufung zu erreichen, muß die Summe der zehn Nachbrennzeiten < 50 s sein und kein Einzelwert darf > 10 s sein. Besonders bei dünnen Wandstärken von 1,6 mm und darunter ist diese Forderung nur sehr schwer zu erfüllen.

Eine V-O-Einstufung wird bei Epoxidharzen nur durch den Zusatz hoher Konzentrationen an halogenhaltigen Flammschutzmitteln erreicht, gegebenenfalls in Kombination mit synergistisch wirkenden Additiven. Das weltweit zur FR4-Leiterplattenfertigung eingesetzte Epoxidharz enthält beispielsweise, auf das Harz bezogen, ca. 30 bis 40 % kernbromierte aromatische Epoxid-Komponenten, d.h. ca. 17 bis 21 % Brom. Die im technischen Einsatz befindlichen Epoxidharz-Formmassen bestehen zu 70 bis 80 % aus unbrennbaren anorganischen Füllstoffen; der verbleibende Reaktionsharzanteil wird durch erhebliche Anteile an bromierten Verbindungen in Kombination mit Antimontrioxid schwerbrennbar eingestellt. Die Problematik bei diesen Verbindungen besteht aber darin, daß sie einerseits zwar als Flammschutzmittel hervorragend wirksam sind, andererseits aber auch sehr bedenkliche Eigenschaften besitzen. So steht Antimontrioxid auf der Liste der krebserregenden Chemikalien, und aromatische Bromverbindungen spalten bei der thermischen Zersetzung nicht nur Bromradikale und Bromwasserstoff ab, die zu starker Korrosion führen, bei der Zersetzung in Gegenwart von Sauerstoff können insbesondere die hochbromierten Aromaten vielmehr auch die hochtoxischen Polybromdibenzofurane und Polybromdibenzodioxine bilden. Erhebliche Schwierigkeiten bereitet ferner die Entsorgung von bromhaltigen Altwerkstoffen und Giftmüll.

Hinsichtlich der geforderten Glasübergangstemperatur $T_G > 200$ °C wurde für Leiterplatten und Formstoffe der Einsatz von Harzsystemen auf Basis Polyimid oder Bismaleinimid/Triazin vorgeschlagen (siehe: "Galvanotechnik", Bd. 80 (1989), Seiten 1737 bis 1741). Diese Harzsysteme sind aber wesentlich teurer als Epoxidharze (Faktor 6 bis 10) sowie schwerer ver- und bearbeitbar, so daß auch die Verarbeitungskosten wesentlich höher als bei Epoxidharzen sind; der technische Einsatz bleibt deshalb auf Spezialanwendungen beschränkt. Da diese Systeme inhärent nicht schwerbrennbar sind, müssen sie zur Erreichung der geforderten Schwerbrennbarkeit - wie Epoxidharze - durch Zugabe von aromatischen halogenierten Verbindungen schwerentflammbar eingestellt werden. Das hat aber, neben der bereits erwähnten Gefährdung im Brandfall (Bildung hochtoxischer Verbindungen), eine Reduzierung der thermisch-mechanischen Eigenschaften, beispielsweise durch Herabsetzung der Glasübergangstemperatur, zur Folge. So sinkt die Glasübergangstemperatur von Polyimiden von Werten von 260 bis 270 °C bis auf Werte von 200 °C, diejenige von Bismaleinimid/Triazin-Systemen von 200 °C auf ca. 180 °C.

Ein vergleichsweise kostengünstiges Harzsystem ist ein System auf der Basis von Epoxiden mit 1.3.5-Tris(3-amino-4-alkylphenyl)-2.4.6-trioxohexahydrotriazinen als Härter (siehe: EP-OS 0 271 772 und EP-OS 0 274 646). Dieses System besitzt eine Glasübergangstemperatur von ca. 240 °C, ist jedoch ebenfalls nach UL 94V nicht ausreichend schwerbrennbar. Durch Zugabe von üblichen aromatischen Halogenverbindungen wird zwar eine V-O-Einstufung erreicht, allerdings kommt es auch dabei zu einer Reduzierung der Glasübergangstemperatur auf ca. 185 °C.

Aromatische Amine, wie 4.4′-Diaminodiphenylmethan und 4.4′-Diaminodiphenylsulfon, ergeben zusammen mit geeigneten Epoxiden ebenfalls Polymere mit $T_G > 200$ °C. Auch hier sind aber zur Erzielung einer

ausreichenden Schwerbrennbarkeit weitere Maßnahmen, wie die Zugabe halogenierter aromatischer Verbindungen (mit den bereits beschriebenen unerwünschten Auswirkungen auf die Materialeigenschaften), notwendig. Allerdings scheitert der technische Einsatz dieser Systeme vor allem daran, daß die sowohl für Prepregs als auch für Formmassen bis zur Weiterverarbeitung geforderte Lagerstabilität nicht erreicht wird.

Es sind zahlreiche Vorschläge bekannt, weniger problematische Substanzen als halogenierte Verbindungen zur Erhöhung der Schwerbrennbarkeit einzusetzen (siehe dazu: J.W. Lyons "The Chemistry and Uses of Fire Retardants", Wiley Interscience, New York, 1970). So wird der Einsatz verschiedener Füllstoffe, wie Aluminiumhydroxid, Magnesiumhydroxid und Zinkcarbonat, empfohlen. Diese Füllstoffe verdanken ihre Wirksamkeit der Abspaltung von unbrennbaren Gasen (Löschgase), wodurch die Konzentration brennbarer Gase in der Flamme stark erniedrigt wird und es infolgedessen zu einer Reduzierung der Brennbarkeit kommt. Aluminiumoxidhydrate spalten beispielsweise bei 180 bis 200 °C Wasser ab; das dabei gebildete Aluminiumoxid wirkt zusammen mit den Verkohlungsprodukten als isolierende Schutzschicht und behindert dadurch zusätzlich den Brennprozeß. Wegen des notwendig hohen Anteils dieser Füllstoffe in den Reaktionsharzmischungen kommt es jedoch zu einer Reduzierung der mechanischen, dielektrischen und chemischen Eigenschaften der Reaktionsharzformstoffe. Da Füllstoffe grundsätzlich zur Sedimentation neigen, ist ferner, insbesondere hinsichtlich der erforderlichen hohen Füllgrade für die Leiterplattenfertigung, eine aufwendigere und damit teurere Verarbeitungstechnik erforderlich. Der Einsatz dieser Füllstoffe mit der Zielsetzung, Werkstoffe mit hoher Glasübergangstemperatur ($T_G$ > 200 °C) bereitzustellen, ist allerdings irrelevant, da die bei den erforderlichen Verarbeitungstemperaturen von über 200 °C freigesetzten Löschgase eine irreversible Schädigung der Formstoffe bewirken würden.

Es ist ferner bereits bekannt, daß Phosphor bzw. Phosphate die Brennbarkeit von duroplastischen Polymeren herabsetzen (siehe dazu: US-A 2 766 139 und US-A 3 398 019 sowie W.C. Kuryla und A.J. Papa "Flame Retardancy of Polymeric Materials", Vol. 1, Seiten 24 bis 38 und 52 bis 61, Marcel Dekker Inc., New York, 1973). Da Phosphate jedoch "weichmachende" Eigenschaften besitzen, d.h. die Glasübergangstemperatur herabsetzen, und auch im großen Maßstab als Weichmacher für Polymere eingesetzt werden, scheidet ihr Einsatz bei der vorgegebenen Zielsetzung aus. Grundsätzlich ist die Verwendung von Phosphaten als Additive aber auch deshalb als weniger erfolgversprechend zu bewerten, da es bei den hohen Verarbeitungs- und Nachhärtungstemperaturen der Polymeren zum Ausschwitzen ("plate out") der Phosphate kommen kann, wodurch die Flammschutzwirkung und die dielektrischen Eigenschaften der Formstoffe negativ beeinflußt werden.

Was die Verwendung von rotem Phosphor als Flammschutzmittel anbetrifft, so haben eigene Untersuchungen mit Epoxidharzen gezeigt, daß - offensichtlich als Folge der zum Erreichen der Schwerbrennbarkeitsanforderungen erforderlichen hohen Konzentration an Phosphor (> 15 %, bezogen auf die Harzmatrix) - die technischen Anforderungen an die E-Korrosionsbeständigkeit der Formstoffe nicht erfüllt werden können. Es ist zwar prinzipiell möglich, die Konzentration an rotem Phosphor durch Kombination mit den bereits erwähnten Füllstoffen mit Löschgaswirkung zu reduzieren und dennoch die Anforderungen an die Schwerbrennbarkeit zu erfüllen. Dabei wird insbesondere die Kombination mit Aluminiumoxidhydraten vorgeschlagen (EP-A 0 249 723, US-A 4 145 369), und teilweise wird sogar die Zugabe weiterer Füllstoffe, wie Molybdänoxid (JP-A 54-003 152) und Zirkonoxid (JP-A 56-034 746) oder Kombinationen aus Magnesiumhydroxid, Magnesiumcarbonat und Zinkcarbonat (JP-A 59-170 176), zu Mischungen aus Epoxidharzen mit Aluminiumoxidhydraten und rotem Phosphor als wirksam beschrieben. Allerdings haben eigene Untersuchungen gezeigt, daß es bei gängigen Epoxidharzsystemen nicht möglich ist, bei der in der Elektronik überwiegend geforderten Wandstärke von 1,6 mm über die Kombination von rotem Phosphor mit Aluminiumoxidhydrat Schwerbrennbarkeit mit einer V-O-Einstufung nach UL 94V zu erreichen. Unter Berücksichtigung ausreichender mechanischer und dielektrischer Eigenschaften ist eine derartige Einstufung vielmehr erst bei Wandstärken > 3 mm zu erreichen.

Insbesondere die Verwendung von Aluminiumoxidhydraten scheidet jedoch wegen der bei Verarbeitungsbedingungen erfolgenden Wasserabspaltung für den angestrebten Zweck aus. Außerdem kommt es beim Einsatz der vor stehend genannten Füllstoffe zu einer Beeinträchtigung der mechanischen, chemischen und dielektrischen Eigenschaften, beispielsweise des elektrischen Widerstandes der erhaltenen Formstoffe (siehe: "Interflam '88", Tagungsbericht (1988), Seiten 223 bis 229). Bei gleichzeitiger Verwendung von rotem Phosphor und wasserabspaltenden Füllstoffen kann es außerdem zu starker Geruchsbelästigung durch die Bildung von Phosphin kommen.

Alle bislang bekannten Maßnahmen zur halogenfreien schwerbrennbaren Einstellung von Epoxidharzformstoffen sind somit entweder ungeeignet für Formstoffe mit $T_G$ > 200 °C oder bedingen eine nicht tolerierbare Beeinträchtigung der für Leiterplatten und Bauteilumhüllungen geltenden Anforderungen oder sie führen letztendlich zu unwirtschaftlichen Harzsystemen.

Aufgabe der Erfindung ist es, Epoxidharzmischungen zur Herstellung von Formstoffen und Verbundwerkstoffen anzugeben, die kostengünstig zugänglich und vergleichbar den im technischen Einsatz befindlichen Epoxidharzmischungen verarbeitbar sind und - ohne Zusatz von Halogenverbindungen oder Antimontrioxid - schwerbrennbare, d.h. entsprechend UL 94V nach V-O einstufbare Formstoffe bzw. Verbundwerkstoffe mit einer möglichst hohen Glasübergangstemperatur (> 200 °C), einem möglichst geringen Ausdehnungskoeffizienten (~ 15 bis $25.10^{-6}$ $K^{-1}$) und ausreichend guten dielektrischen Eigenschaften, die sich auch während der Gebrauchsdauer, beispielsweise durch E-Korrosion, nicht ändern dürfen, liefern.

Dies wird erfindungsgemäß dadurch erreicht, daß die Epoxidharzmischungen folgende Komponenten enthalten:

(A) ein phosphorfreies aromatisches und/oder heterocyclisches polyepoxidharz, gegebenenfalls in Abmischung mit einem aliphatischen Epoxidharz,

(B) gekapselten roten Phosphor,

(C) ein aromatisches Polyamin folgender Struktur als Härter:

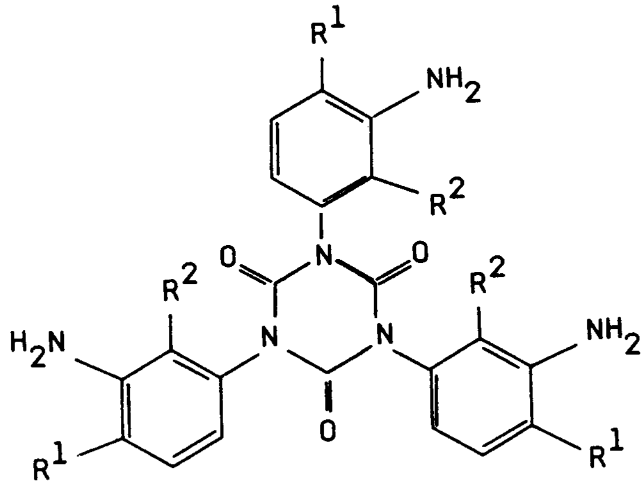

wobei an jeder der drei aromatischen Partialstrukturen jeweils einer der Reste $R^1$ und $R^2$ Wasserstoff (H) und der andere Alkyl bedeutet, und

(D) Füllstoff bzw. eine Einlagerungskomponente.

Es wurde nämlich völlig überraschend gefunden, daß Mischungen aus den vor stehend genannten Komponenten polymerwerkstoffe ergeben, die sich im ausgehärteten Zustand, selbst bei dünnen Wandstärken, durch ein hohes thermisch-mechanisches Eigenschaftsniveau ($T_G$ > 200 °C) bei gleichzeitiger V-O-Einstufung nach UL 94V auszeichnen. Die Zugabe weiterer Flammschutzmittel in Form von Füllstoffen, wie Hydroxiden oder Oxidhydraten, bzw. in Form von Harzbestandteilen, wie Phosphaten oder Halogenverbindungen, ist dabei nicht notwendig. Die erfindungsgemäßen Mischungen sind nach üblichen Verfahren einfach und somit kostengünstig verarbeitbar, zudem erfüllen sie hinsichtlich der E-Korrosion und der elektrischen Werte alle wesentlichen an Leiterplattenmaterialien bzw. Formmassen gestellten Anforderungen.

Diese Tatsache ist überraschend, weil eigene Untersuchungen gezeigt haben, daß mit rotem Phosphor flammfest eingestellte Epoxidharze, wie sie technisch zur Leiterplattenfertigung und Preßmassenherstellung benutzt werden, zu E-Korrosion neigen. Als Erklärung des geschilderten Befundes wird bei den erfindungsgemäßen Epoxidharzmischungen ein Zusammenwirken zwischen dem aromatischen Polyamin und dem roten Phosphor angenommen, das die Schwerbrennbarkeit erhöht und die E-Korrosion verhindert.

Als Polyepoxidharz, d.h. Polyglycidylverbindung, eignen sich insbesondere folgende Verbindungen: aromatische Polyglycidylether, wie Bisphenol-A-diglycidylether, Bisphenol-F-diglycidylether und Bisphenol-S-diglycidylether, Polyglycidylether von Phenol/Formaldehyd-Harzen und Kresol/Formaldehyd-Harzen, Resorcindiglycidylether und Tetrakis(p-glycidylphenyl)-ethan, Di- bzw. Polyglycidylester von Phthal-, Isophthal- und Terephthalsäure sowie von Trimellithsäure, N-Glycidylverbindungen von aromatischen Aminen und heterocyclischen Stickstoffbasen, wie N.N-Diglycidylanilin, N.N.O-Triglycidyl-p-aminophenol, Triglycidylisocyanurat und N.N.N'.N'-Tetraglycidyl-bis(p-aminophenyl)-methan, Hydantoin-Epoxidharze und Uracil-Epoxidharze sowie Di- und Polyglycidylverbindungen von mehrwertigen aliphatischen Alkoholen, wie 1.4-Butandiol, Trimethylolpropan und Polyalkylenglykolen. Ferner sind als Komponente (A) auch modifizierte Epoxidharze

geeignet, beispielsweise oxazolidinonmodifizierte Epoxidharze. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Als weitere Beispiele für modifizierte Epoxidharze seien die Umsetzungsprodukte von Epoxidharzen mit aminmodifizierten Bismaleinimiden genannt.

Die Polyepoxidharze können in den erfindungsgemäßen Epoxidharzmischungen einzeln oder im Gemisch vorliegen. Bevorzugt wird als Polyepoxidharz ein epoxidierter Novolak, vorzugsweise mit einem Gehalt an hydrolysierbarem Halogen < 0,1 %, verwendet.

Als Komponente (B) wird gekapselter roter Phosphor verwendet; als Coating dienen dabei insbesondere Epoxidharze, Polyurethanharze und Phenol-Formaldehydharze. Der Phosphorgehalt liegt im allgemeinen zwischen 0,1 und 5 Masse-%, bezogen auf das Gesamtsystem; vorzugsweise beträgt der Phosphorgehalt zwischen 0,5 und 3 Masse-%.

Die in den erfindungsgemäßen Epoxidharzmischungen als Härter dienenden aromatischen Polyamine sind zum Teil bereits bekannt. Polyamine der angegebenen Struktur mit $R^1$ = Alkyl und $R^2$ = H sind in der EP-OS 0 271 772 beschrieben. Sie werden durch Trimerisierung von 2.4-Diisocyanato-alkylbenzolen und nachfolgende Hydrolyse der verbleibenden Isocyanatgruppen hergestellt. Verbindungen mit $R^1$ = H und $R^2$ = Alkyl werden analog durch Trimerisierung von 2.6-Diisocyanato-alkylbenzolen und nachfolgende Hydrolyse erhalten. Als Komponente (C) können in den erfindungsgemäßen Epoxidharzmischungen sowohl Polyamine der beiden vorstehend genannten Arten als auch Gemische dieser Verbindungen verwendet werden. Darüber hinaus können auch Polyamine eingesetzt werden, die durch Trimerisierung von Gemischen aus 2.4- und 2.6-Diisocyanato-alkylbenzolen und nachfolgende Hydrolyse der Trimerisate erhalten werden. Derartige Gemische sind großtechnisch zugänglich und erlauben eine kostengünstige Herstellung der Härterkomponente.

Bei der Hydrolyse der isocyanatgruppenhaltigen Trimerisierungsprodukte kann es auch zu einer Reaktion zwischen Isocyanatgruppen und Aminogruppen kommen. Dabei werden, als Nebenprodukt der Hydrolysereaktion, heterocyclische Polyamine mit Harnstoffgruppierungen erhalten. Derartige Polyamine können in den erfindungsgemäßen Epoxidharzmischungen als additive Härterkomponente eingesetzt werden, d.h. im Gemisch mit dem eigentlichen Härter zum Einsatz gelangen. Neben dem eigentlichen Härter bzw. neben Härtergemischen der vorstehend genannten Art können in den Epoxidharzmischungen auch aromatische Polyamine anderer Art, wie 4.4'-Diaminodiphenylmethan und 4.4'-Diaminodiphenylsulfon, und/oder andere heterocyclische Polyamine eingesetzt werden. Der Anteil derartiger Polyamine im Härtergemisch beträgt im allgemeinen maximal 30 Masse-%.

Das Verhältnis zwischen eingesetzter Epoxidfunktion (Komponente A) und eingesetzter Aminwasserstoff-Funktion NH (Komponente C) kann bei den erfindungsgemäßen Epoxidharzmischungen 0,9:1 bis 1,1:1 betragen, vorzugsweise beträgt es etwa 1:1.

Zur Herstellung von Prepregs werden Polyepoxid und Polyamin getrennt in einem Lösungsmittel gelöst. Als besonders geeignet haben sich dabei ketonische Lösungsmittel, wie Aceton und Methylethylketon, sowie Dimethylformamid und Dimethylacetamid erwiesen. In die vereinigten Lösungen wird die erforderliche Menge an gekapseltem roten Phosphor eingerührt. Mit der dabei erhaltenen Lösung mit suspendiertem Phosphor werden nach üblichen Verfahren Prepregs hergestellt. Diese Prepregs sind klebfrei und bei Raumtemperatur mindestens drei Monate lagerstabil. Nach Verpreßen bei ca. 180 °C und Nachhärten bis 200 °C werden aus den Prepregs Verbundwerkstoffe erhalten, die eine Glasübergangstemperatur $T_G$ > 220 °C aufweisen. Bei der Verwendung von Glasgewebe als Verstärkungsmaterial mit einem Masseanteil von ca. 50 bis 60 % kann beispielsweise ein Basismaterial für Leiterplatten hergestellt werden, das selbst bei Wandstärken von 1,6 mm und geringer eine V-O-Einstufung nach UL 94V zeigt, ohne daß weitere Flammschutzmittel, wie Halogenverbindungen, notwendig sind. Hierdurch kommt es im Brandfall nicht zur Bildung von hochtoxischen Zersetzungsprodukten, und die Rauchentwicklung ist wesentlich geringer als bei halogenhaltigen Epoxidharzen. Zur Herstellung von Formmassen können die einzelnen Komponenten (Polyepoxid, Polyamin, roter Phosphor und Füllstoff, wie Quarzgutmehl) auf verschiedene Weise vermischt werden. Abhängig von der Konsistenz des verwendeten Epoxids kann die Aufbereitung entweder trocken, beispielsweise in der Kugelmühle oder auf dem Walzenstuhl, eventuell bei leicht erhöhter Temperatur, oder über eine Lösung, mit anschließendem Entfernen des Lösungsmittels im Vakuum, erfolgen. Auf diese Weise wird ein trockenes, rieselfähiges, homogenes Granulat erhalten, das zu Tabletten geformt werden kann. Diese Tabletten sind bei Raumtemperatur mindestens ein Jahr lagerstabil und übertreffen somit die geforderte Lagerstabilität von sechs Monaten bei weitem.

Als Füllstoff bzw. Einlagerungskomponente werden pulverförmige mineralische Stoffe und/oder Kurzfasern verwendet. Beispiele für derartige Füllstoffe sind Aluminiumoxid, Siliciumdioxid, Calciumsilicate,

insbesondere Wollastonit, und Carbonate, wie Dolomit. Von besonderem Interesse für Anwendungen in der Elektrotechnik sind $\alpha$-strahlungsarme Füllstoffe, insbesondere Bergkristall und Siliciumdioxid, wie sie aus der DE-OS 33 23 844 bekannt sind. Der Anteil an Füllstoff bzw. Einlagerungskomponente in den Formmassen beträgt im allgemeinen 50 bis 90 Masse-%, vorzugsweise 60 bis 80 Masse-%.

Die Verarbeitung der Formmassen erfolgt beispielsweise nach dem Transferpreßverfahren. Bei Temperaturen oberhalb 150 °C erfolgt dabei eine sehr schnelle Vernetzung, so daß die Formstoffe bereits nach wenigen Minuten aus der Presse entnommen werden können. Die Glasübergangstemperaturen liegen beispielsweise bei Verwendung von epoxidiertem Novolak bereits beim Entformen bei über 200 °C und können durch Nachhärten bis auf ca. 250 °C erhöht werden.

Allgemein zeichnen sich die über Prepregs bzw. Preßmassen nach gängigen Verarbeitungstechniken erhaltenen Verbundwerkstoffe und Formstoffe durch ein hohes thermisch-mechanisches Eigenschaftsniveau aus. Trotz der hohen Glasübergangstemperatur zeigen die Verbundwerkstoffe und Formstoffe ein sehr gutes mechanisches Verhalten (Biegefestigkeit, Schlagzähigkeit). Darüber hinaus besitzen sie einen kleinen linearen thermischen Ausdehnungskoeffizienten, der über einen weiten Temperaturbereich konstant ist. Dies ist besonders wichtig bei Materialien, die für die Umhüllung von Bauelementen verwendet werden, bzw. bei Verbundwerkstoffen, die über einen weiten Temperaturbereich besonders dimensionsstabil sein müssen. Weiterhin besitzen diese Materialien eine gute Haftung zu Metallen, wie Kupfer.

Anhand von Ausführungsbeispielen soll die Erfindung noch näher erläutert werden.

Beispiel 1: Herstellung von Prepregs

Eine Lösung von A Masseteilen (MT) eines Epoxidharzes in B Masseteilen Ethylmethylketon wird zu einer Lösung von C Masseteilen eines Polyamins, das durch Trimerisierung einer 4:1-Mischung aus Toluol-2.4-diisocyanat und Toluol-2.6-diisocyanat und nachfolgende Hydrolyse (zu einem Produkt mit einem $NH_2$-Wert von 8,7 %) hergestellt wurde, in D Masseteilen Ethylmethylketon gegeben. Zu den vereinigten Lösungen werden E Masseteile von mit Phenolformaldehydharz gekapseltem roten Phosphor gegeben (Phosphor-Anteil: 85 %). Die Zusammensetzung verschiedener Epoxidharzmischungen ist Tabelle 1 zu entnehmen. Mit diesen Mischungen werden Glasgewebe (Leinwandbindung, Flächengewicht: 197 g/m²) imprägniert und in einer Vertikaltrockenanlage bei 50 bis 130 °C getrocknet. Die so hergestellten Prepregs sind klebfrei und bei Raumtemperatur ohne Konditionierung mindestens drei Monate lagerstabil.

Tabelle 1

| Versuchs-Nr. | 1 | 2 | 3 | 4 | 5 |
|---|---|---|---|---|---|
| Komponenten: | | | | | |
| A (MT) | 66[1)] | 66[1)] | 66[1)] | 66[2)] | 60[3)] |
| B (MT) | 18 | 18 | 18 | 18 | 15 |
| C (MT) | 34 | 34 | 34 | 33 | 33 |
| D (MT) | 34 | 34 | 34 | 33 | 33 |
| E (MT) | 0 | 5 | 7 | 7 | 6 |
| roter Phosphor (%[4)]) | 0 | 2 | 2,8 | 2,8 | 2,4 |
| Prepreg: | | | | | |
| Restgehalt an Lösungsmittel (%) | 0,4 | 0,4 | 0,4 | 0,4 | 0,3 |
| Restgelierzeit bei 170 °C (s) | 47 | 48 | 47 | 42 | 61 |

[1)] epoxidierter Novolak: Epoxidwert: 0,57; Viskosität bei 80 °C: 1500 mPa.s
[2)] epoxidierter Novolak: Epoxidwert: 0,54; Viskosität bei 150 °C: 600 cSt
[3)] Bisphenol-F-diglycidylether: Epoxidwert: 0,61; Viskosität bei 25 °C: 1200 ± 100 mPa.s
[4)] bezogen auf Formstoff mit 60 % Glasanteil

Beispiel 2: Herstellung von Laminaten

Je acht der nach Beispiel 1 erhaltenen Prepregs werden in einer Presse bei 175 °C und 70 bar verpreßt. Die 1,6 mm dicken Laminate werden nach 10 min aus der Presse entfernt und anschließend 2 h

bei 200 °C nachgehärtet. Bei den auf diese Weise erhaltenen Körpern wird die Glasübergangstemperatur ($T_G$) und die Brennbarkeit nach UL 94V ermittelt. Die Werte sind in Tabelle 2 zusammengefaßt (Versuchsnummern entsprechend denen von Beispiel 1).

Tabelle 2

| Versuchs-Nr. | 1 | 2 | 3 | 4 | 5 |
|---|---|---|---|---|---|
| Meßwerte: | | | | | |
| $T_G$ (°C) | 240 | 240 | 240 | 250 | 225 |
| mittlere Brenndauer nach UL 94V[1)] (s) | > 45 | 4,5 | 3 | 2,5 | 3 |
| Einstufung | nicht einstufbar | V-O | V-O | V-O | V-O |

[1)] Schichtdicke: 1,6 mm

Beispiel 3: Herstellung von Leiterplattenbasismaterial

Stapel von je acht Lagen der nach Beispiel 1 hergestellten Prepregs werden außen beidseitig mit je einer Kupferfolie (Dicke: 18 µm) belegt und bei 175 °C und 70 bar 30 min verpreßt. Das auf diese Weise erhaltene Basismaterial wird anschließend 2 h in einem Umluftofen bei 200 °C nachgehärtet. Die an dem Basismaterial gemessenen Prüfwerte sind in Tabelle 3 zusammengefaßt (die Versuchsnummern entsprechen denen von Beispiel 1).

Tabelle 3

| Versuchs-Nr. | 1 | 2 | 3 | 4 | 5 |
|---|---|---|---|---|---|
| Meßwerte: | | | | | |
| Haftvermögen der Cu-Folie bei Raumtemperatur (N/mm) | 1,5 | 1,6 | 1,6 | 1,6 | 1,5 |
| Lagenbindung: Kugeltest | + | + | + | + | + |
| Lötbadtest: 288°C/20 s | + | + | + | + | + |
| Wasseraufnahme (%) | 0,30 | 0,28 | 0,32 | 0,26 | 0,30 |
| Oberflächenwiderstand (Ω) | $8.10^{13}$ | $8.10^{13}$ | $7.10^{13}$ | $8.10^{13}$ | $6.10^{13}$ |
| Dielektrizitätskonstante (bei 1 MHz) | 4,88 | 4,89 | 4,80 | 4,80 | 4,81 |
| mittlere Brenndauer nach IEC 249-1 (s) | 5,1 | < 1 | < 1 | < 1 | < 1 |
| Schneidbarkeit nach DIN 53488 | + | + | + | + | + |
| Bohrer-Verschleißprüfung | + | + | + | + | + |
| Oberflächenkorrosion nach IPC-B-25 | + | + | + | + | + |
| Schnittkantenkorrosion nach IEC 249-1 | + | + | + | + | + |

("+" bedeutet: bestanden)

Beispiel 4: Herstellung von Formmassen

A Masseteile eines Epoxidharzes, B Masseteile eines entsprechend Beispiel 1 hergestellten Polyamins, C Masseteile von mit Phenolformaldehydharz gekapseltem roten Phosphor (Amgard CRP) und D Masseteile

Quarzgutmehl (Silbond FW 12 EST) werden bei ca. 50 °C 30 min auf einem Walzenstuhl vermischt. Dabei wird ein trockenes, rieselfähiges Granulat erhalten, das bei Raumtemperatur und erhöhtem Druck zu Tabletten verarbeitet wird. Dieses Material ist nach einjähriger Lagerung bei Raumtemperatur unverändert verarbeitbar, d.h. es weist eine sehr hohe Lagerstabilität auf. Die Zusammensetzung der einzelnen Mischungen ist in Tabelle 4 aufgeführt.

Tabelle 4

| Versuchs-Nr. | 6 | 7 | 8 | 9 | 10 |
|---|---|---|---|---|---|
| Komponenten: | | | | | |
| A (MT) | 66[1)] | 66[1)] | 66[1)] | 66[2)] | 66[3)] |
| B (MT) | 34 | 34 | 34 | 33 | 36 |
| C (MT) | 0 | 3 | 5 | 5 | 5 |
| D (MT) | 233 | 230 | 228 | 228 | 229 |

[1)] epoxidierter Novolak: Epoxidwert: 0,57; Viskosität bei 80 °C: 1500 mPa.s
[2)] epoxidierter Novolak: Epoxidwert: 0,54; Viskosität bei 150 °C: 600 cSt
[3)] Bisphenol-F-diglycidylether: Epoxidwert: 0,61; Viskosität bei 25 °C: 1200 ± 100 mPa.s

Beispiel 5: Herstellung von Formstoffen

Die nach Beispiel 4 hergestellten Tabletten werden im Transferpreßverfahren zu Prüfkörpern und zu 1,6 mm dicken Platten verarbeitet. Die Temperatur der Presse beträgt dabei 175 °C, der Preßdruck 100 bar und die Formbelegungszeit 5 min. Nach dieser Zeit werden die Proben aus der Presse entnommen und dann 2 h bei 190 °C und 2 h bei 210 °C nachgehärtet. Die an diesen Proben gemessenen Werte sind in Tabelle 5 aufgeführt (die Versuchsnummern entsprechen denen von Beispiel 4).

Tabelle 5

| Versuchs-Nr. | 6 | 7 | 8 | 9 | 10 |
|---|---|---|---|---|---|
| Meßwerte: | | | | | |
| Glasübergangstemperatur $T_G$ (°C) | | | | | |
| - nach Verpressen | 210 | 210 | 210 | 210 | 210 |
| - nach Tempern | 245 | 240 | 245 | 255 | 230 |
| Biegefestigkeit ($N/mm^2$) | 135 ± 20 | 130 ± 22 | 138 ± 28 | 150 ± 22 | 126 ± 18 |
| Schlagzähigkeit ($Nmm/mm^2$) | 6,2 ± 1,0 | 5,9 ± 1,1 | 5,8 ± 1,3 | 4,7 ± 1,0 | 6,4 ± 1,0 |
| mittlere Brenndauer nach UL 94V[1)] (s) | > 45 | 4,5 | < 1 | < 1 | 1,4 |
| Einstufung | nicht einstufbar | V-0 | V-0 | V-0 | V-0 |

1) Schichtdicke: 1,6 mm

Vergleichsbeispiel 1:

Um mit dem technischen Stand bei der Preßmassenverarbeitung vergleichen zu können, wird versucht, ein gängiges Epoxidharz mit rotem Phosphor flammhemmend einzustellen. Dazu werden - in Anlehnung an

kommerziell erhältliche Preßmassen für die Elektronik - jeweils 175 Masseteile eines epoxidierten Novolaks (Epoxidwert: 0,57) und 110 Masseteile eines Phenolnovolaks (OH-Wert: 0,91) mit unterschiedlichen Mengen an mit Phenolformaldehydharz gekapseltem roten Phosphor sowie mit verschiedenen Anteilen an Quarzgutmehl (Silbond FW 12 EST) und Aluminiumoxidhydrat analog Beispiel 4 vermischt. Die Mischungen werden bei 175°C zu Formstoffen verpreßt und diese 5 h bei 175°C nachgehärtet. Tabelle 6 enthält die Zusammensetzung der untersuchten Mischungen und die an den Formstoffen gemessenen Eigenschaftswerte.

Die Werte in Tabelle 6 belegen, daß selbst mit sehr hohen Phosphoranteilen die in der Mikroelektronik bei 1,6 mm dicken Probekörpern geforderte V-O-Einstufung nach UL 94V nicht erreicht werden kann. die ebenfalls geforderte Korrosionsprüfung nach DIN 53 489 ergibt deutlich stärkere Verfärbungen als die in der Mikroelektronik akzeptierte Grenzeinstufung AN 1,4.

Tabelle 6

| Versuchs-Nr. | 11 | 12 | 13 | 14 |
|---|---|---|---|---|
| Komponenten: | | | | |
| epoxidierter Novolak (MT) | 175 | 175 | 175 | 175 |
| Phenolnovolak (MT) | 110 | 110 | 110 | 110 |
| roter Phosphor (MT) | 60 | 130 | 60 | 60 |
| roter Phosphor (%[1)]) | 7,5 | 15 | 7,5 | 7,5 |
| Quarzgutmehl (MT) | 455 | 455 | 320 | 135 |
| Aluminiumoxidhydrat (MT) | - | - | 135 | 320 |
| Formstoffeigenschaften: | | | | |
| Glasübergangstemperatur $T_G$ (°C) | 180 | 180 | 175 | 170 |
| Brennprüfung nach UL 94V: | | | | |
| 1,6 mm-Proben: Brenndauer (s)/Einstufung | > 45/keine | 35/keine | > 45/keine | 32/keine |
| 3,2 mm-Proben: Brenndauer (s)/Einstufung | 32/keine | 4,2/V-0 | 23/V-1 | 4,4/V-0 |
| Korrosionsprüfung nach DIN 53 489: | | | | |
| Kennwert | AN 1,8 | A/B 2 | A/B 2 | B 3 |
| Bewertung | nicht bestanden | nicht bestanden | nicht bestanden | nicht bestanden |

1) bezogen auf das Gesamtsystem

Vergleichsbeispiel 2:

Um mit dem technischen Stand bei der Leiterplattenherstellung vergleichen zu können, werden 350 Masseteile Bisphenol-A-diglycidylether (Epoxidwert: 0,57) jeweils mit einer Lösung von 42 Masseteilen

Dicyandiamid in 42 Masseteilen Dimethylformamid sowie mit 4,2 Masseteilen Dimethylbenzylamin und mit unterschiedlichen Mengen an mit Phenolformaldehydharz gekapseltem roten Phosphor in 170 Masseteilen Methylethylketon gemischt. Die Viskosität der Lösungen wird durch weitere Zugabe von Methylethylketon so eingestellt, daß sich die Lösungen zum Imprägnieren von Glasgewebe (Leinwandbindung, Flächengewicht: 197 g/m$^2$) verwenden lassen; während des Imprägniervorganges werden die Lösungen gerührt. Das imprägnierte Glasgewebe wird in einer Vertikaltrockenanlage bei 50 bis 150 °C getrocknet und danach zu Prepregs zugeschnitten. Je acht Prepregs werden in einer Presse bei 175 °C/70 bar zu 1,6 mm dickem Leiterplattenbasismaterial verpreßt. Die daraus gewonnenen Probekörper werden auf das Brennverhalten nach UL 94V geprüft. Die dabei erhaltenen Werte sind in Tabelle 7 zusammengestellt.

Die Werte in Tabelle 7 zeigen, daß mit 5 und 10 % rotem Phosphor keine Einstufung nach UL 94V erzielt werden kann. Mit einem Anteil von 15 % rotem Phosphor werden bei der Brennprüfung nach UL 94V stark schwankende Werte von < 5 s bis > 45 s erhalten, was auf eine inhomogene Verteilung des roten Phosphors in den Prüfkörpern schließen läßt und belegt, daß mit derart hohen Phosphorkonzentrationen, trotz gerührter Imprägnierlösungen, keine einwandfreie Verarbeitung zu Prepregs mehr möglich ist.

Tabelle 7

| Versuchs-Nr. | 15 | 16 | 17 |
|---|---|---|---|
| **Komponenten:** | | | |
| Bisphenol-A-diglycidylether (MT) | 350 | 350 | 350 |
| Dicyandiamid (MT) | 42 | 42 | 42 |
| Dimethylbenzylamin (MT) | 4,2 | 4,2 | 4,2 |
| roter Phosphor (MT) | 50 | 115 | 200 |
| roter Phosphor (%[1]) | 5 | 10 | 15 |
| **Formstoffeigenschaften:** | | | |
| Brennprüfung nach UL 94V: 1,6 mm-Proben: Brenndauer (s)/Einstufung | > 45/keine | > 45/keine | stark schwankende Werte, keine Einstufung möglich |

1) bezogen auf Formstoff mit ca. 55 % Glasanteil

## Patentansprüche

**1.** Epoxidharzmischungen zur Herstellung von Formstoffen und Verbundwerkstoffen, folgende Komponenten enthalted:

(A) ein phosphorfreies aromatisches und/oder heterocyclisches Polyepoxidharz, gegebenenfalls in Abmischung mit einem aliphatischen Epoxidharz,
(B) gekapselten roten Phosphor,wobei der Gehalt an rotem Phosphor zwischen 0,1 und 5 Masse-% beträgt, bezogen auf das Gesamtsystem,
(C) ein aromatisches Polyamin folgender Struktur als Härter:

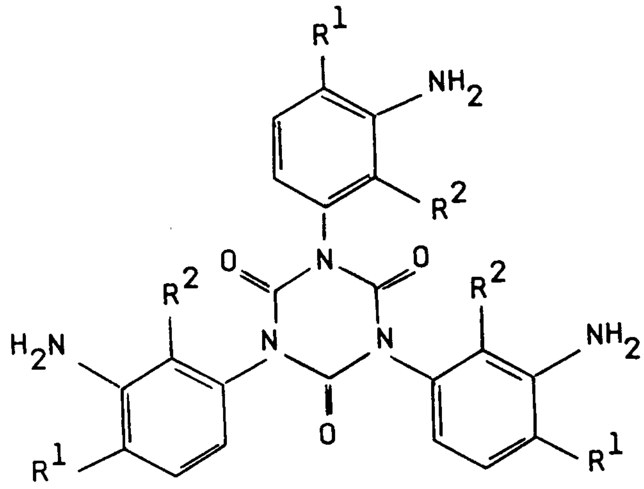

wobei an jeder der drei aromatischen Partialstrukturen jeweils einer der Reste $R^1$ und $R^2$ Wasserstoff und der andere Alkyl bedeutet, und
(D) Füllstoff bzw. eine Einlagerungskomponente.

2. Epoxidharzmischungen nach Anspruch 1, **dadurch gekennzeichnet,** daß das Polyepoxidharz ein epoxidierter Novolak ist, vorzugsweise mit einem Gehalt an hydrolysierbarem Halogen < 0,1 Masse-%.

3. Epoxidharzmischungen nach Anspruch 1 oder 2, **dadurch gekennzeichnet,** daß der Gehalt an rotem Phosphor zwischen 0,5 und 3 Masse-% beträgt.

4. Epoxidharzmischungen nach einem der Ansprüche 1 bis 3, **dadurch gekennzeichnet,** daß der rote Phosphor mit Epoxidharz, Polyurethanharz oder Phenol-Formaldehydharz gekapselt ist.

5. Epoxidharzmischungen nach einem oder mehreren der Ansprüche 1 bis 4, **dadurch gekennzeichnet,** daß die Komponente (C) ein Gemisch aus Polyaminen ist, hergestellt durch Trimerisierung eines Gemisches aus 2.4- und 2.6-Diisocyanato-alkylbenzolen und nachfolgende Hydrolyse.

6. Epoxidharzmischungen nach einem oder mehreren der Ansprüche 1 bis 5, **dadurch gekennzeichnet,** daß die Komponente (C) im Gemisch mit weiteren aromatischen und/oder heterocyclischen Polyaminen als Härter vorliegt.

7. Epoxidharzmischungen nach einem oder mehreren der Ansprüche 1 bis 6, **dadurch gekennzeichnet,** daß das Verhältnis zwischen Epoxidfunktion und Aminwasserstoff-Funktion 0,9:1 bis 1,1:1 beträgt, vorzugsweise 1:1.

8. Epoxidharzmischungen nach einem oder mehreren der Ansprüche 1 bis 7, **dadurch gekennzeichnet,** daß der Füllstoff $\alpha$-strahlungsarmes Quarzgutmehl ist.

9. Epoxidharzmischungen nach einem oder mehreren der Ansprüche 1 bis 7, **dadurch gekennzeichnet,** daß die Einlagerungskomponente Kurzfasern sind.

10. Epoxidharzmischungen nach einem oder mehreren der Ansprüche 1 bis 9, **dadurch gekennzeichnet,** daß der Anteil an Füllstoff bzw. Einlageungskomponente 50 bis 90 Masse-% beträgt, vorzugsweise 60 bis 80 Masse-%.

11. Formstoffe und Verbundwerkstoffe, hergestellt aus Epoxidharzmischungen nach einem oder mehreren der Ansprüche 1 bis 10.

12. Leiterplatten aus Prepregs, hergestellt aus Glasfasergewebe und Epoxidharzmischungen nach einem oder mehreren der Ansprüche 1 bis 10.

## Claims

1. Epoxy resin mixtures for the production of moulded materials and composite materials, comprising the following components:
   (A) a phosphorus-free aromatic and/or heterocyclic polyepoxy resin, optionally mixed with an aliphatic epoxy resin ,
   (B) encapsulated red phosphorus, the content of red phosphorus being between 0.1 and 5 mass %, based on the system as a whole,
   (C) an aromatic polyamine of the following structure as hardener:

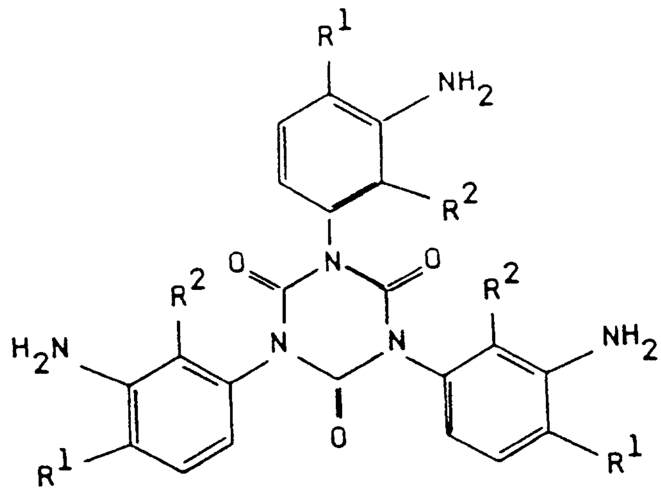

   wherein in each of the three aromatic partial structures one of the radicals $R^1$ and $R^2$ signifies hydrogen and the other alkyl, and
   (D) filler or a reinforcing component.

2. Epoxy resin mixtures according to claim 1, characterised in that the polyepoxy resin is an epoxidised novolac, preferably with a content of hydrolysable halogen < 0.1 mass %.

3. Epoxy resin mixtures according to claim 1 or claim 2, characterised in that the content of red phosphorus is between 0.5 and 3 mass %.

4. Epoxy resin mixtures according to one of claims 1 to 3, characterised in that the red phosphorus is encapsulated with epoxy resin, polyurethane resin or phenol/formaldehyde resin.

5. Epoxy resin mixtures according to one or more of claims 1 to 4, characterised in that the component (C) is a mixture of polyamines, prepared by trimerisation of a mixture of 2,4- and 2,6-diisocyanatoalkylbenzenes and subsequent hydrolysis.

6. Epoxy resin mixtures according to one or more of claims 1 to 5, characterised in that the component (C) is present mixed with further aromatic and/or heterocyclic polyamines as hardener.

7. Epoxy resin mixtures according to one or more of claims 1 to 6, characterised in that the ratio between epoxide function and amine hydrogen function is from 0.9:1 to 1.1:1, and is preferably 1:1.

8. Epoxy resin mixtures according to one or more of claims 1 to 7, characterised in that the filler is low $\alpha$-radiation fused quartz powder.

9. Epoxy resin mixtures according to one or more of claims 1 to 7, characterised in that the reinforcing component is short fibres.

10. Epoxy resin mixtures according to one or more of claims 1 to 9, characterised in that the proportion of filler or reinforcing component is from 50 to 90 mass %, and is preferably from 60 to 80 mass %.

11. Moulded materials and composite materials, made from epoxy resin mixtures according to one or more of claims 1 to 10.

12. Circuit boards made from prepregs produced from glass fibre fabrics and epoxy resin mixtures according to one or more of claims 1 to 10.

**Revendications**

1. Mélanges à base de résine époxy pour la préparation de matériaux de moulage et de matériaux composites, contenant les composants suivants :
(A) une résine polyépoxy aromatique et/ou hétérocyclique, exempte de phosphore, le cas échéant en mélange avec une résine époxy aliphatique,
(B) du phosphore rouge encapsulé, la teneur en phosphore rouge se situant entre 0,1 et 5 % massiques, par rapport au système total,
(C) une polyamine aromatique présentant la structure suivante, en tant que durcisseur :

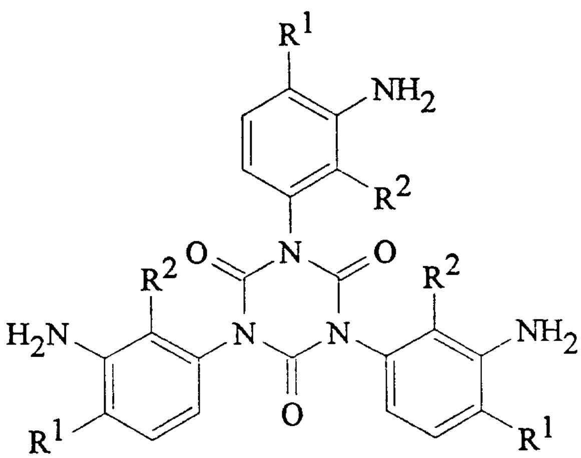

où à chacune des trois structures aromatiques partielles, un des résidus $R^1$ et $R^2$ représente, respectivement, un atome d'hydrogène et l'autre un groupe alkyle, et
(D) de la matière de charge, respectivement un composant d'insertion.

2. Mélanges à base de résine époxy selon la revendication 1, caractérisés en ce que la résine polyépoxy est une novolaque époxydée, de préférence avec une teneur en halogène hydrolysable < 0,1 % massique.

3. Mélanges à base de résine époxy selon la revendication 1 ou 2, caractérisés en ce que la teneur en phosphore rouge se situe entre 0,5 et 3 % massiques.

4. Mélanges à base de résine époxy selon une des revendications 1 à 3, caractérisés en ce que le phosphore rouge est encapsulé par de la résine époxy, par de la résine polyuréthanne ou par de la résine du type phénol-formaldéhyde

5. Mélanges à base de résine époxy selon une ou plusieurs des revendications 1 à 4, caractérisés en ce que le composant (C) est un mélange de polyamines, préparé par trimérisation d'un mélange de 2,4- et

2,6-diisocyanatoalkylbenzènes et par l'hydrolyse subséquente.

**6.** Mélanges à base de résine époxy selon une ou plusieurs des revendications 1 à 5, caractérisés en ce que le composant (C) se trouve en mélange avec d'autres polyamines aromatiques et/ou hétérocycliques en tant que durcisseur.

**7.** Mélanges à base de résine époxy selon une ou plusieurs des revendications 1 à 6, caractérisés en ce que le rapport entre les fonctions époxy et les fonctions hydrogène d'amine s'élève de 0,9 : 1 à 1,1 : 1, de préférence à 1 : 1.

**8.** Mélanges à base de résine époxy selon une ou plusieurs des revendications 1 à 7, caractérisés en ce que la matière de charge est de la poudre de silice vitreuse à faible émission de radiations $\alpha$.

**9.** Mélanges à base de résine époxy selon une ou plusieurs des revendications 1 à 7, caractérisés en ce que le composant d'insertion est composé de fibres courtes.

**10.** Mélanges à base de résine époxy selon une ou plusieurs des revendications 1 à 9, caractérisés en ce que la traction en matière de charge, respectivement en composant d'insertion, s'élève de 50 à 90 % massiques, de préférence de 60 à 80 % massiques.

**11.** Matériaux de moulage et matériaux composites, préparés à partir de mélanges à base de résine époxy selon une ou plusieurs des revendications 1 à 10.

**12.** Cartes imprimées constituées de feuilles préimprégnées, préparées à partir de tissu de fibres de verte et de mélanges à base de résines époxy selon une ou plusieurs des revendications 1 à 10.